(19) Europäisches Patentamt
European Patent Office
Office européen des brevets

(11) **EP 2 106 022 A1**

## (12) EUROPEAN PATENT APPLICATION

(43) Date of publication:
**30.09.2009 Bulletin 2009/40**

(51) Int Cl.:
**H03F 1/02** (2006.01)     **H03F 1/52** (2006.01)

(21) Application number: **09154441.1**

(22) Date of filing: **05.03.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **25.03.2008 JP 2008077797**

(71) Applicant: **Fujitsu Limited**
**Kawasaki-shi, Kanagawa 211-8588 (JP)**

(72) Inventors:
• **Maeda, Hiroaki**
 **Kawasaki-shi**
 **Kanagawa 211-8588 (JP)**

• **Honda, Hirotake**
 **Kawasaki-shi**
 **Kanagawa 211-8588 (JP)**
• **Okazaki, Yousuke**
 **Kawasaki-shi**
 **Kanagawa 211-8588 (JP)**
• **Shizawa, Yoshinobu**
 **Kawasaki-shi**
 **Kanagawa 211-8588 (JP)**

(74) Representative: **Weihs, Bruno Konrad**
 **Haseltine Lake LLP**
 **Lincoln House, 5th Floor**
 **300 High Holborn**
 **London WC1V 7JH (GB)**

(54) **Amplification apparatus and amplifier failure detecting method**

(57)     An amplification apparatus including a plurality of amplifiers includes a carrier amplifier; a peak amplifier including a gate bias circuit including a resistor for supplying a gate bias voltage, a comparator for outputting a resultant signal determined by comparison of a predetermined threshold voltage with a voltage across the resistor included within the gate bias circuit, and a failure detecting circuit for detecting whether a failure in the plurality of amplifiers is caused or not based on the resultant signal.

Fig. 1

**Description**

FIELD

The embodiments discussed herein are related to a technology for detecting a failure in an amplification apparatus.

BACKGROUND

A Doherty amplifier is known as one of means and so on for achieving an efficiency improvement in a power amplifier. The Doherty amplifier is constituted by a carrier amplifier and a peak amplifier connected in parallel. In the Doherty amplifier, when an input power level is high, both of the carrier amplifier and the peak amplifier operate and output power of both the amplifiers are combined and output. Thus, the Doherty amplifier has a large saturation power and achieves high-efficiency amplification.

The operation principle of the Doherty amplifier will be briefly described below. Since a bias for the peak amplifier is set so that it operates as a class-B amplifier or a class-C amplifier, the output impedance thereof varies in accordance with an input power level. Thus, in the Doherty amplifier, a load impedance connected to the output-side of the carrier amplifier is varied in accordance with an output impedance of the peak amplifier, and the varied load impedance causes an output power level and a gain of the carrier amplifier to vary in accordance with the load impedance.

On the other hand, when the input power level is low, the peak amplifier enters an OFF state (a low-gain state) because of the above-described bias setting. At this time, the carrier amplifier operates so as to accomplish a low-saturation output power and a high gain, and the Doherty amplifier operates at a high gain on the whole so as to compensate for the low gain of the peak amplifier. Thus, even when the output is low, the Doherty amplifier achieves high-efficiency amplification.

Some techniques for detecting a failure in such a Doherty amplifier in operation have been proposed (refer to documents below)

Japanese Unexamined Utility Model Application Publication No. 5-28111
Japanese Laid-open Patent Publication No. 2003-143833
Japanese Laid-open Patent Publication No. 2007-300528

As a technique for detecting a failure in the Doherty amplifier, for example, a technique for detecting a failure by monitoring a gain fluctuation in the entire Doherty amplifier and an output signal thereof is available. With this technique, since a substantial gain decrease occurs when the carrier amplifier fails, it is possible to detect the failure by detecting a gain fluctuation and an output-power decrease.

However, when the peak amplifier fails, the gain decrease is very small. Thus, it is impossible to detect the failure based on the gain fluctuation and an output-power decrease. This is because, when the input power level for the Doherty amplifier is low, the peak amplifier enters the OFF state, as described above, and thus has an output impedance that is approximately equal to that when a failure occurs.

A technique for detecting a failure in the peak amplifier based of a gate bias voltage supplied to a transistor by utilizing a change in the gate bias voltage during a failure has been proposed (refer to the document described above: Japanese Laid-open Patent Publication No. 2007-300528).

With this technique, however, when a non-insulated-gate-structure transistor, such as a gallium nitride high-electron-mobility transistor (GaN HEMT) or a gallium arsenide field-effect transistor (GaAs FET), is used for the peak amplifier, a failure cannot be properly detected in some cases.

SUMMARY

An object of the present invention is to provide a technology for detecting a failure in an amplifying apparatus including a Doherty amplifier by using a simple configuration, regardless of characteristics of a transistor used.

According to an aspect of the invention, an amplification apparatus including a plurality of amplifiers includes a carrier amplifier, a peak amplifier including a gate bias circuit including a resistor for supplying a gate bias voltage, a comparator for outputting a resultant signal determined by comparison of a predetermined threshold voltage with a voltage across the resistor included within the gate bias circuit; and a failure detecting circuit for detecting whether a failure in the plurality of amplifiers is caused or not based on the resultant signal.

According to another aspect of the invention, an amplifier failure detecting method for detecting a failure in a plurality of amplifiers including a carrier amplifier and a peak amplifier includes comparing a predetermined threshold voltage with a voltage drop across a resistor included within a circuit for supplying a gate bias voltage to the peak amplifier, outputting a resultant signal determined in the comparing; and detecting and outputting a first signal which detects whether a failure in the plurality of amplifiers is caused or not based on the resultant signal. An amplifier failure detecting method for detecting a failure in a plurality of amplifiers including a carrier amplifier and a peak amplifier includes comparing a predetermined threshold voltage with a value of a voltage drop across a resistor included within a circuit for supplying a gate bias voltage to the peak amplifier, outputting a resultant signal decided in the comparing, and detecting and outputting a first signal which identifies whether a failure in the plurality of amplifiers is caused or not based on the resultant signal.

The object and advantages of the invention will be realized and attained by means of the elements and combinations particularly pointed out in the claims.

It is to be understood that both the foregoing general description and the following detailed description are exemplary and explanatory and are not restrictive of the invention, as claimed.

BRIEF DESCRIPTION OF THE DRAWINGS

Fig. 1 illustrates a diagram depicting a schematic circuit configuration of an amplifying apparatus in an embodiment;
Fig. 2 illustrates a diagram depicting a detailed configuration of a gain detecting circuit and a failure detecting circuit in the embodiment;
Fig. 3 illustrates a diagram depicting one example of a detailed circuit configuration of the amplifying apparatus;
Fig. 4 illustrates a diagram depicting an example of detecting a failure in a peak amplifier when an insulated-gate-structure transistor is used for the peak amplifier;
Fig. 5 illustrates a diagram depicting an example of detecting a failure in the peak amplifier when a non-insulated-gate-structure transistor is used for the peak amplifier; and
Fig. 6 is a diagram depicting an example of the operation of the amplifying apparatus in the embodiment.

DESCRIPTION OF EMBODIMENTS

An amplifying apparatus according to an embodiment will be described below with reference to the drawings. The amplifying apparatus in the embodiment is incorporated into a wireless transmitter/receiver, such as a mobile terminal or a base-station apparatus. The amplifying apparatus in the embodiment does not restrict equipment into which it is incorporated, and is incorporated into a circuit to simplify the power of a predetermined signal, such as an analog signal or digital signal. The configuration of the embodiment described below is illustrative, and the present invention is not limited to the configuration of the embodiment described below.

[Circuit Configuration]

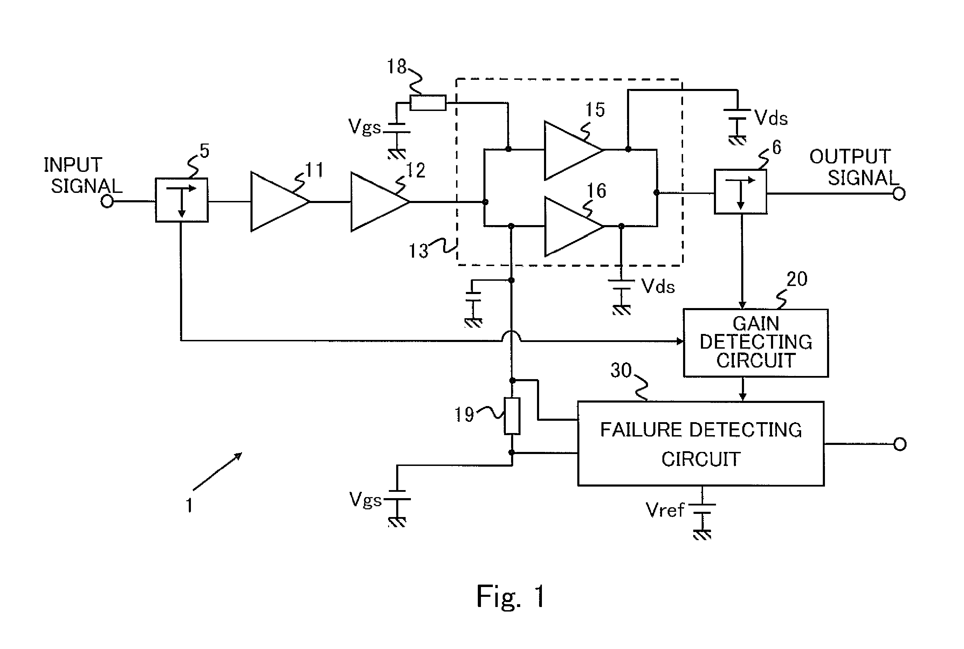

An overview of the circuit configuration of an amplifying apparatus according to the embodiment will be described. Fig. 1 is a diagram depicting a schematic circuit configuration of the amplifying apparatus in the embodiment.

As illustrated in Fig. 1, an amplifying apparatus 1 in the embodiment has a first-stage amplifier 11, a middle-stage amplifier 12, a last-stage amplifier 13, a gain detecting circuit 20, a failure detecting circuit 30, and so on. The last-stage amplifier 13 is a Doherty amplifier and includes a carrier amplifier 15 and a peak amplifier 16. That is, the amplifying apparatus 1 in the embodiment includes a Doherty amplifier.

The amplifying apparatus 1 detects a failure in the internal amplifiers (the first-stage amplifier 11, the middle-stage amplifier 12, and the last-stage amplifier 13) in such a circuit configuration including the Doherty amplifier 13. The amplifying apparatus 1 outputs an output signal resulting from amplification of an input signal and also outputs a signal indicating a failure when the failure in the internal amplifiers is detected. The gain detecting circuit 20 and the failure detecting circuit 30 in the amplifying apparatus 1 achieve the failure detection.

The gain detecting circuit 20 obtains the input signal and the output signal via directional couplers 5 and 6 and obtains a total gain of the amplifying apparatus 1 based on the input signal and the output signal. When the total gain becomes lower than a rated gain, the gain detecting circuit 20 outputs a predetermined signal to the failure detecting circuit 30.

The failure detecting circuit 30 measures a potential difference between two opposite ends of a resistor (a gate bias resistor) 19 disposed in a gate bias circuit for the peak amplifier 16 in the last-stage amplifier 13. When the two-opposite-end potential difference exceeds a predetermined threshold, the failure detecting circuit 30 generates a predetermined signal. Based on this predetermined signal and the predetermined signal sent from the gain detecting circuit 20, the failure detecting circuit 30 outputs a predetermined signal indicating that at least one of the amplifiers included in the amplifier 1 has failed.

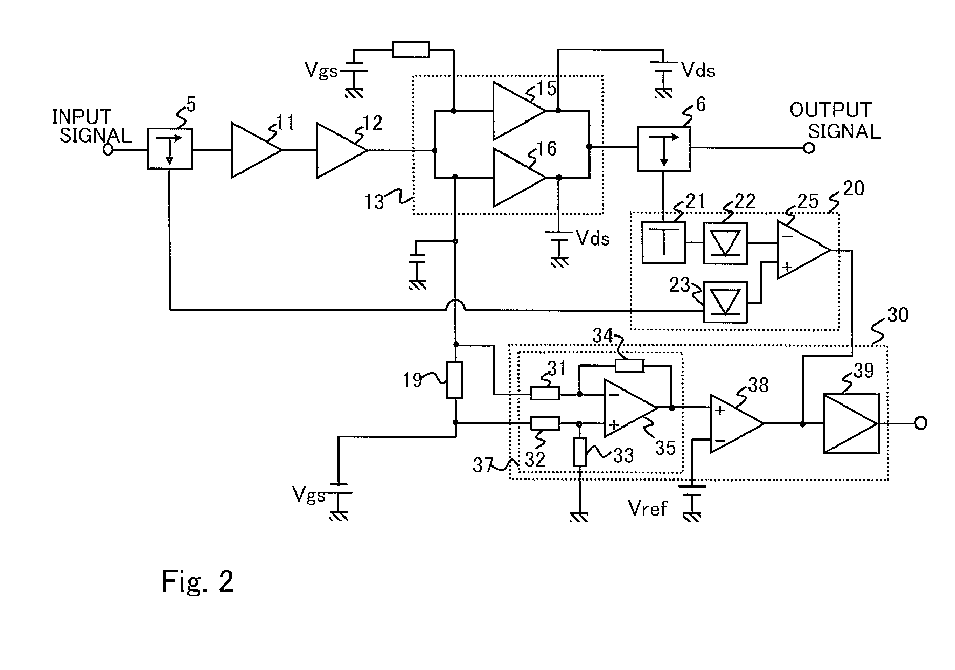

Fig. 2 is a diagram depicting a detailed configuration of the gain detecting circuit 20 and the failure detecting circuit 30 in the embodiment.

The gain detecting circuit 20 has an attenuator 21, power detecting circuits 22 and 23, a comparator, 25, and so on.

An output signals amplified step-by-step by the first-stage amplifier 11, the middle-stage amplifier 12, and the last-stage amplifier 13 is received by the directional coupler 6 and split thereby, then received by the attenuator 21. The attenuator 21 attenuates the received signal and sends the attenuated signal to the power detecting circuit 22. The amount of attenuation is set so as to correspond to the total gain (the gains of the amplifiers 11, 12, and 13) of the amplifying apparatus 1. That is, the attenuator 21 adjusts the power level of the signal (the output signal), split by the directional coupler 6, to substantially the power level of the input signal.

The power detecting circuit 22 detects power of the signal from the attenuator 21 to obtain a direct-current voltage. The power detecting circuit 22 outputs the direct-current voltage to the comparator 25.

The power detecting circuit 23 receives a signal resulting from splitting of the input signal, the splitting being performed by the directional coupler 5. The power detecting circuit 23 detects power of the received signal (the input signal) to obtain a direct-current voltage. The power detecting circuit 23 outputs the direct-current voltage to the comparator 25.

The comparator 25 compares the direct-current voltage received from the power detecting circuit 22 with the direct-current voltage received from the power detecting circuit 23. The comparator 25 outputs a predetermined voltage corresponding to the result of the comparison of both the direct-current voltages. When the gain of the amplifying apparatus 1 is a rated gain, i.e., when all the internal amplifiers are operating properly, the comparator 25 outputs a predetermined voltage X. Both of the voltages in this case are approximately equal to each other.

On the other hand, when the gain of the amplifying apparatus is smaller than the rated gain, i.e., when at least one of the first-stage amplifier 11, the middle-stage amplifier 12, and the carrier amplifier 15 in the last-stage amplifier 13 fails, the comparator 25 outputs a voltage that is lower than the voltage X by $\alpha$ corresponding to the voltage difference. In this case, the direct-current voltage received from the power detecting circuit 22 is lower than the direct-current voltage received from the power detecting circuit 23.

As described above, the gain detecting circuit 20 detects the total gain of the amplifying apparatus 1 based on the input signal and output signal extracted by the directional couplers 5 and 6, and detects a failure in the internal amplifiers based on the total gain. According to the gain detecting circuit 20, it is possible to reliably detect a failure in the first-stage amplifier 11, the middle-stage amplifier 12, and the carrier amplifier 15 in the last-stage amplifier 13. This is because, when a failure occurs in the first-stage amplifier 11, the middle-stage amplifier 12, and the carrier amplifier 15, the gain decreases significantly and the difference between the signal power levels of the input signal and the output signal increases.

However, when the peak amplifier 16 in the last-stage amplifier 13 fails, the amount of variation in the gain is small, as described above. Thus, the gain detecting circuit 20 may not detect the failure in the peak amplifier 16.

The failure detecting circuit 30 is used for detecting a failure in the peak amplifier 16. The failure detecting circuit 30 combines a detected failure of the peak amplifier 16 and an another-amplifier failure from the gain detecting circuit 20 to output a signal indicating a failure detection result of the entire amplifying apparatus 1.

[Detailed Circuit Configuration of Failure Detecting Circuit]

<Detection of Failure in Peak Amplifier 16>

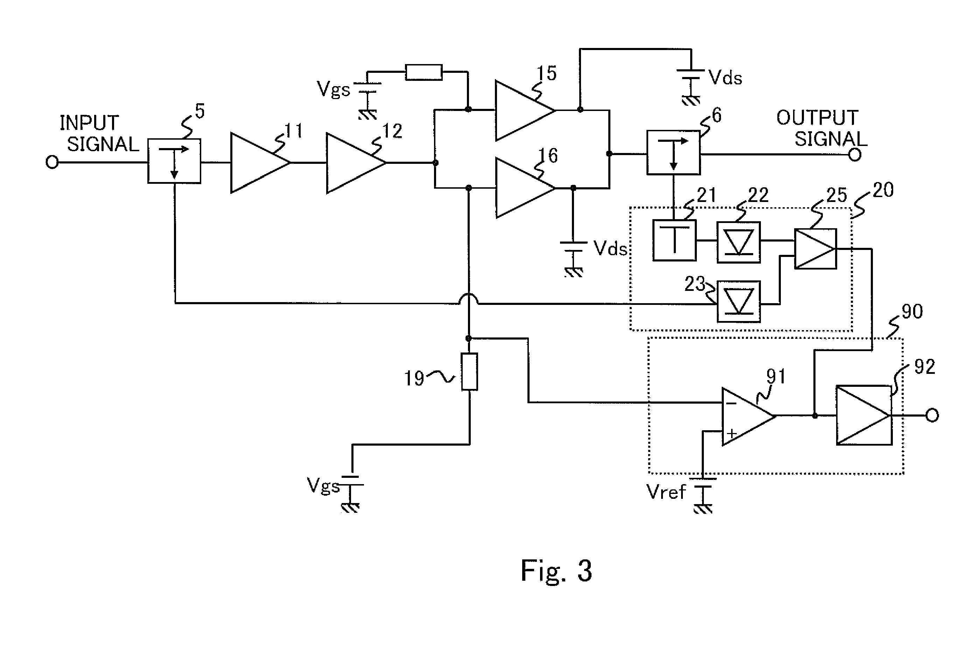

Fig. 3 is a diagram depicting one example of a detailed circuit configuration of the amplifying apparatus.

A failure detecting circuit 90 detects a failure in the peak amplifier 16. The failure detecting circuit 90 extracts a gate bias voltage of the peak amplifier 16 and a comparator 91 compares the gate bias voltage with a preset abnormality-detection set voltage (Vref illustrated in Fig. 3, hereinafter expressed as Vref). The comparator 91 outputs a voltage corresponding to the difference between the gate bias voltage and Vref.

That is, when the peak amplifier 16 is operating properly, Vref is lower than the gate bias voltage and thus the low-side voltage is output from the comparator 91. On the other hand, when the peak amplifier 16 fails, insulation breakdown of the gate electrode or the like reduces the gate resistance and thus the gate bias voltage decreases. Accordingly, when the peak amplifier 16 fails, Vref becomes higher than the gate bias voltage and thus the high-side voltage is output from the comparator 91.

The above-described failure detection technique for the peak amplifier 16 is preferable when the gate bias resistor 19 connected to the peak amplifier 16 has a high resistance. When the gate bias resistor 19 has a high resistance, the gate bias resistor 19 causes a large voltage drop compared to a case of the normal operation, in response to a decrease in the impedance of the gate due to a failure of the transistor of peak amplifier 16. This allows the voltage drop to be easily detected even in this circuit configuration.

However, for a transistor (hereinafter expressed as a non-insulated-gate-structure transistor), such as a GaN HEMT or GaAs FET, that has a metal-semiconductor gate junction structure (a schottky junction), the gate current is on the order of microamperes ($\mu$A), which is 1000 times greater than that of an insulated-gate-structure-type transistor, such as an Laterally Diffused MOS (LDMOS). As a result, when the gate bias resistance of the non-insulated-gate-structure transistor is set to a high resistance, thermal runaway occurs in the insulated-gate-structure-type transistor. The thermal runaway occurs according to, for example, a principle as follows. When the ambient temperature rises, the gate current increases. When the gate current increases, the gate current and the gate resistance cause the gate voltage to shift in a direction in which a large amount of the drain current flows. The shift in the gate voltage causes the drain current to increase. An increase in the drain current causes the transistor temperature to rise, so that the gate current increases. Repetition of such a cycle causes the thermal runaway. Consequently, in the non-insulated-gate structure transistor, the gate bias resistance thereof may not be set to be a high resistance.

Even when such a non-insulated-gate-structure transistor is used, it is desirable that a gate bias resistor having a load with a certain level of resistance be provided in order to reduce oscillation around the bias circuit.

When a non-insulated-gate-structure transistor as described above is used for the peak amplifier 16, the gate bias resistor 19 is set low to the extent that it is possible to prevent oscillation while preventing thermal runaway. That is, when a non-insulated-gate-structure transistor such as a GaN HEMT or GaAs FET is used, the gate bias resistance 19 is generally set low, compared to a case in which an LDMOS transistor or the like is used.

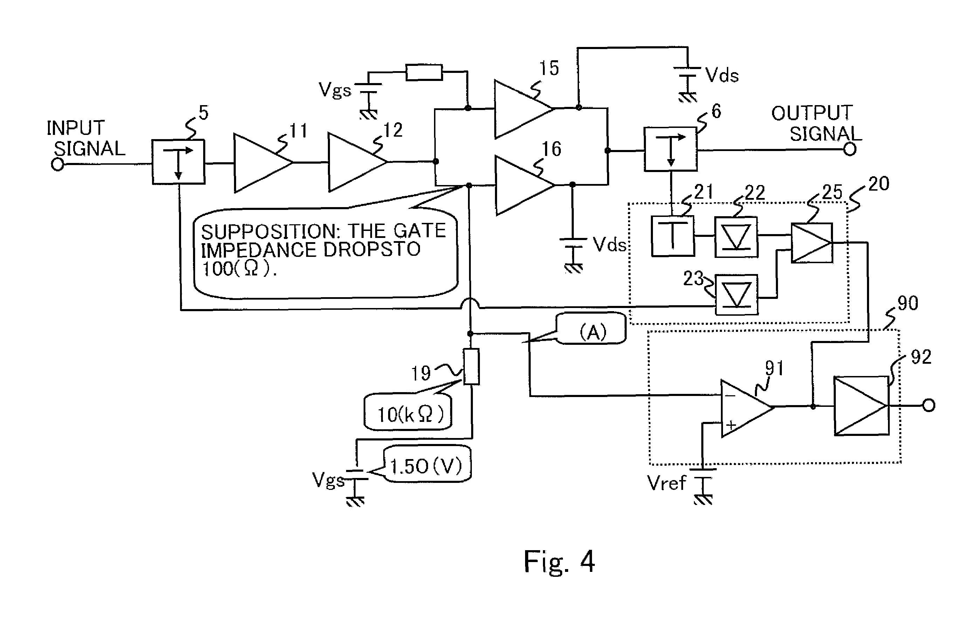

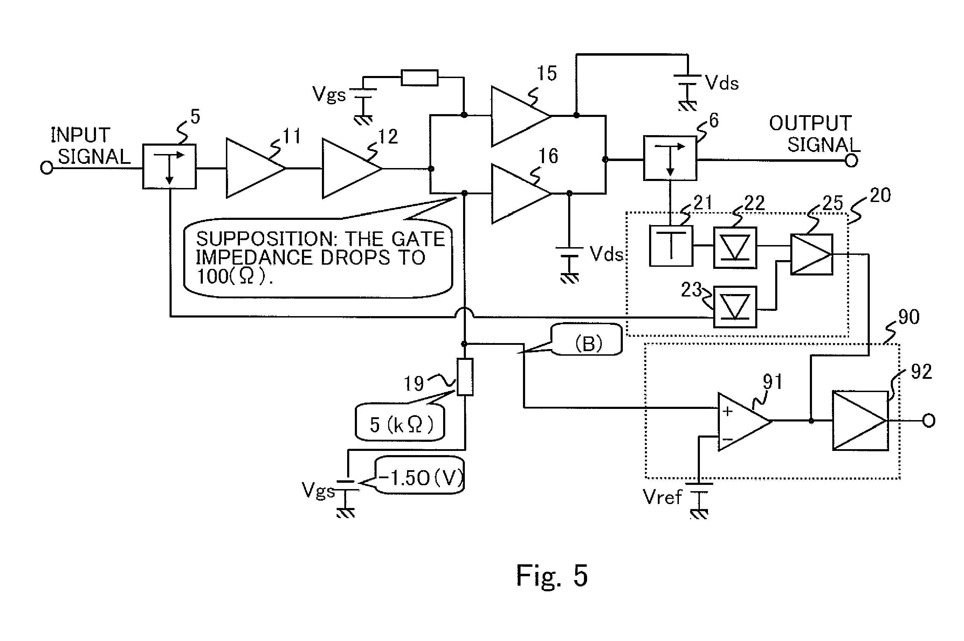

When the gate bias resistor 19 is set low as described above, it is not easy to detect a decrease in the gate bias voltage by using this circuit configuration. Through the use of Figs. 4 and 5, an example of detecting a failure in the peak amplifier will be described below in connection with a case in which an insulated-gate-structure transistor is used and a case in which a non-insulated-gate-structure transistor is used.

A description is given of a case in which the gate impedance becomes 100 ohms ($\Omega$) due to insulation breakdown (half breakdown) at the gate of the transistor of the peak amplifier. The reason why the case of a half breakdown as the insulation breakdown of the gate is taken is that it can adversely affect its peripheral circuits, while the detection thereof is difficult. On the other hand, when the insulation of the gate is completely broken down, the gate resistor has a value that is close to zero (0). Thus, the decrease in the gate bias voltage becomes prominent and thus the detection is easy.

Fig. 4 is a diagram illustrating an example of detecting a failure in the peak amplifier when an insulated-gate-structure transistor is used for the peak amplifier. In this example, a gate bias voltage (a voltage applied between the gate and the source; hereinafter, Vgs illustrating in the figure) is 1.50 volts (V) and the gate bias voltage resistance is set to 10 kilo-ohms (k$\Omega$).

In this case, when the amplifying apparatus 1 is operating properly, a gate bias voltage ((A) in the figure) is 1.50(V). On the other hand, when the peak amplifier 16 in the amplifying apparatus 1 fails, the gate bias voltage becomes 0.01(V) (= 1.5(V)$\times$100($\Omega$)/(100($\Omega$)+10(k$\Omega$)).

In this manner, when an insulated-gate-structure transistor is used, the gate bias resistance (10 kilo-ohms (k$\Omega$)) can be set high and thus a voltage decrease during a failure is prominent. Thus, it is possible to easily detect the failure, without requiring accuracy for the abnormal-detection set voltage (Vref).

Fig. 5 is a diagram depicting an example of detecting a failure in the peak amplifier when a non-insulated-gate-structure transistor is used for the peak amplifier. In this example, Vgs is set to -1.50(V) and the gate bias resistance is set low (to 5($\Omega$)) because of the above-described characteristics of the non-insulated-gate-structure transistor.

In this case, when the amplifying apparatus 1 is operating properly, a gate bias voltage ((B) in the fig. 5) becomes -1.50(V). On the other hand, when the peak amplifier 16 in the amplifying apparatus 1 fails, the gate bias voltage becomes -1.43(V) (= -1.5(V)$\times$100($\Omega$)/(100($\Omega$)+5($\Omega$)).

In this manner, when a non-insulated-gate-structure transistor is used, it is desirable that the gate bias resistance set low and thus a voltage decrease during a failure is small. In this example, a failure may not be detected unless the abnormal-detection set voltage (Vref) is set to between -1.5(V) and -1.43(V). That is, accuracy is required for Vref and false detection due to noise or the like can also occur. Thus, detecting a failure in the non-insulated-gate-structure transistor is not as easy as detecting a failure in the above-described insulated-gate-structure transistor.

<Detection of Failure in Peak Amplifier 16 in the Embodiment>

Even in a case in which the gate bias resistance of the peak amplifier 16 needs to be a low resistance, such as a case in which a non-insulated-gate-structure transistor is used, the failure detecting circuit 30 in the embodiment reliably can detect a failure in the peak amplifier 16.

The failure detecting circuit 30 in the embodiment has a differential amplifier 37, a comparator 38, and an adder 39. The differential amplifier 37 is constituted by resistors 31, 32, 33, and 34 and an operational amplifier 35. Since the differential amplifier 37 has a typical configuration, a description thereof is omitted herein.

The failure detecting circuit 30 extracts voltages at two opposite ends of the gate bias resistor 19 for the peak amplifier 16, the differential amplifier 37 amplifies the potential difference between the voltages, and the comparator 38 compares the amplified potential difference with the abnormal-detection set voltage (Vref).

The comparator 38 outputs a voltage (illustrated as Vout2) corresponding to the difference between the amplified potential difference and Vref. That is, as in the above-described circuit configuration, the comparator 38 outputs the low-side voltage when the peak amplifier 16 is operating properly, and outputs the high-side voltage when the peak amplifier 16 fails. At this time, since the comparator 38 uses the amplified potential difference between two points, Vref can be set high. That is, the accuracy of Vref may be approximately the same as that in the case in which an insulated-gate-structure transistor is used in the above-described circuit configuration.

The adder 39 combines the voltage output from the comparator 25 in the gain detecting circuit 20 and the voltage output from the comparator 38 and outputs the combined voltage as a warning signal of the amplifying apparatus 1. Specifically, when a malfunction occurs in the first-stage amplifier 11, the middle-stage amplifier 12, and the carrier amplifier 15 in the amplifying apparatus 1, the voltage output from the comparator 25 becomes lower than that (the predetermined voltage X) in the normal operation. Accordingly, the voltage of the signal output from the failure detecting circuit 30 becomes lower than that in the normal operation. On the other hand, when a malfunction occurs in the peak amplifier 16, the high-side voltage is output from the comparator 38 and thus the output voltage becomes higher than that in the normal operation.

Accordingly, another functional unit (circuit) connected to the amplifying apparatus 1 monitors the voltage of the warning signal to thereby allow for detection of a failure in the internal amplifiers in the amplifying apparatus 1.

As described above, according to the embodiment, even when a voltage decrease due to a failure in the peak amplifier 16 is small, the failure can be reliably detected since the potential difference between the two opposite ends of the gate bias resistor 19 is amplified and is then compared with the predetermined threshold.

In the above-described embodiment, the voltage output from the gain detecting circuit 20 has been described as becoming lower when the amplifier fails than that in the normal operation. However, the arrangement may be such that the voltage becomes higher than that in the normal operation. With such an arrangement, even in rare cases such as a case in which the peak amplifier 16 and another amplifier fail at the same time, both of the failures can be detected.

[Example of Operation]

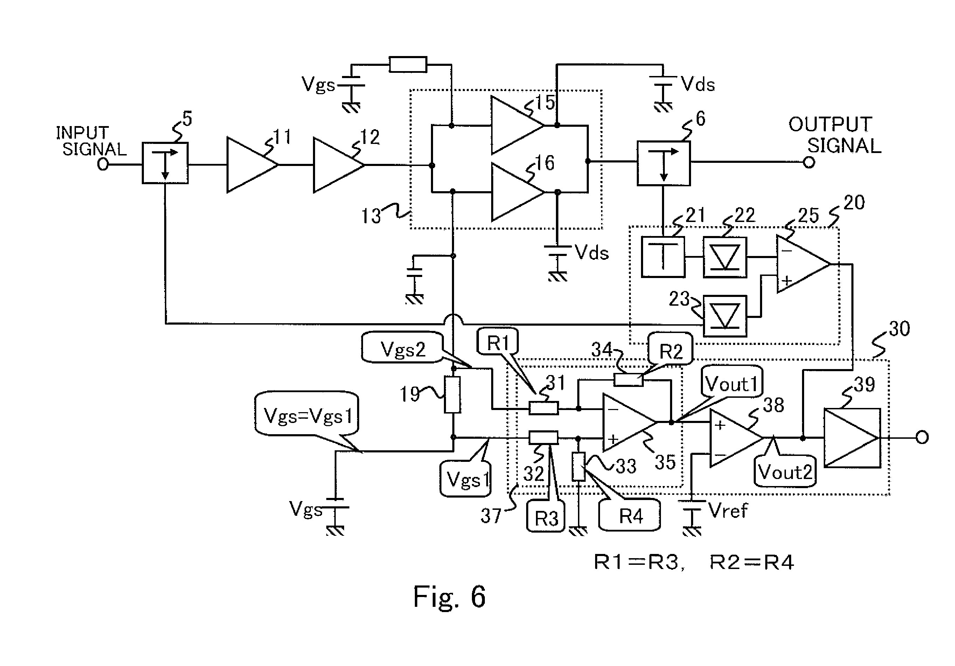

Fig. 6 is a diagram illustrating an example of the operation of the amplifying apparatus 1 in the embodiment.

[During Normal Operation of Transistor]

When a signal having a predetermined power level is input to the amplifying apparatus 1, the directional coupler 5 splits the input signal into the first-stage amplifier 11 and into the gain detecting circuit 20.

The first-stage amplifier 11 and the middle-stage amplifier 12 amplify the input signal by respective predetermined gains step by step. The amplified signal is sent to the last-stage amplifier 13, which is a Doherty amplifier. In the last-stage amplifier 13, at least one of the carrier amplifier 15 and the peak amplifier 16 operates to further amplify the input signal, in accordance with the power level of the signal. The signal further amplified by the last-stage amplifier 13 is output to the outside of the amplifying apparatus 1 via the directional coupler 6.

The gain detecting circuit 20 sequentially receives the input signal extracted by the directional coupler 5 and the output signal extracted by the directional coupler 6. In the gain detecting circuit 20, the power detecting circuit 23 detects power of the input signal and the comparator 25 receives a direct-current voltage corresponding to the input signal obtained by the power detection. With respect to the output signal from the directional coupler 6, the attenuator 21 attenuates the signal by the amount of attenuation corresponding to the gain of the amplifying apparatus 1, the power detecting circuit 22 detects the power of the attenuated input signal, and the comparator 25 receives a direct-current voltage corresponding to the output signal obtained by the power detection.

The comparator 25 compares the direct-current voltage corresponding to the input signal with the direct-current voltage corresponding to the output voltage and outputs a voltage corresponding to the voltage difference therebetween to the failure detecting circuit 30. Thus, when all the internal amplifiers in the amplifying apparatus 1 are operating properly, the gain detecting circuit 20 outputs the predetermined voltage X or a voltage that is approximately equal thereto.

The failure detecting circuit 30 sequentially extracts the potentials at the two opposite ends of the gate bias resistor 19 connected to the peak amplifier 16 in the last-stage amplifier 13. In the failure detecting circuit 30, the differential amplifier 37 amplifies the two-opposite-end potential difference by an amount corresponding to a predetermined gain and the comparator 38 compares the amplified potential difference with Vref. When the potential difference is larger than Vref, the comparator 38 outputs the high-side voltage. Otherwise, the comparator 38 outputs the low-side voltage. Thus, when the peak amplifier 16 is operating properly, the potential difference is zero or a value that is approximately equal thereto and thus the comparator 38 outputs the low-side voltage.

In the example illustrated in Fig. 6, since the potential differences between the two opposite ends of the gate bias resistor 19 for the peak amplifier 16 are approximately equal to each other ($Vgs1 \approx Vgs2$) during the normal operation of the transistor of the peak amplifier 16, the output voltage from the differential amplifier 37 is approximately equal to zero (V) (Vout1 ≈ 0(V)). Thus, the comparator 38 determines that Vout1 is lower than Vref. As a result, the voltage (Vout2) output from the comparator 38 becomes the low-side voltage.

In the failure detecting circuit 30, the voltage output from the comparator 38 and the voltage output from the above-described gain detecting circuit 20 are combined and a signal having the combined voltage is output. Thus, when all the internal amplifiers in the amplifying apparatus 1 are operating properly, a signal having a voltage resulting from the addition of the predetermined voltage X from the gain detecting circuit 20 and the low-side voltage output from the comparator 38 is output. Since the signal has a voltage resulting from the addition of the low-side voltage to the predetermined voltage X, the external functional unit (circuit) for monitoring the signals determines that no failure occurs in the amplifying apparatus 1.

[During Failure in Transistor]

When any of the first-stage amplifier 11, the middle-stage amplifier 12, and the carrier amplifier 15 in the last-stage amplifier 13 fails, the gain of the amplifying apparatus 1 decreases significantly and thus the voltage output from the gain detecting circuit 20 becomes lower than that (the predetermined voltage X) in the normal operation.

On the other hand, when no failure occurs in the peak amplifier 16, the voltage output from the comparator 38 in the failure detecting circuit 30 is the low-side voltage. As a result, since the signal output from the failure detecting circuit 30 is lower than the voltage in the normal operation, it is possible to determine that the amplifying apparatus 1 has failed.

Next, a description will be given of an example of a case in which the only the peak amplifier 16 fails. It is assumed in this case that gate insulation breakdown (half breakdown) occurs in the transistor of the peak amplifier 16 and the gate impedance becomes 100 ohms (Ω). At this time, it is assumed that the gate bias resistor 19 connected to the peak amplifier 16 has 5(Ω) and Vgs is - 1.50(V).

In this case, Vgs1 becomes -1.50(V) and Vgs2 becomes -1.43(V) (= - 1.5(V)×100(Ω)/(100(Ω)+5(Ω))). The differential amplifier 37 amplifies the difference between the two-opposite-end voltages Vgs1 and Vgs2 and outputs an output voltage Vout1 noted below. It is assumed that R1 of the differential amplifier 37 is 1(kΩ) and R2 is 20(kΩ).

$$
\begin{aligned}
\text{Vout1} &= -(\text{Vgs1}-\text{Vgs2}) \times (\text{R2/R1}) \\
&= +0.07(\text{V}) \times (20(\text{k}\Omega)/1(\text{k}\Omega)) \\
&= +1.4(\text{V})
\end{aligned}
$$

It is sufficient to set the values R1, R2, R3, and R4 of the resistors included in the differential amplifier 37 to appropriate amplification factors, so as to facilitate failure detection at their respective subsequent stages.

Although the potential difference between the two opposite ends of the gate bias resistor 19 is small as described above, the voltage Vout1 output from the differential amplifier 37 has the amplified value (1.4(V)). Thus, when Vref is set to +0.5(V), the comparator 38 outputs the high-side voltage since Vout1 is higher than Vref. The bias of the comparator 38 is a single power of positive-voltage application.

In this case, the signal output from the failure detecting circuit 30 has a voltage that results from the combination of the predetermined voltage X output from the gain detecting circuit 20 and the aforementioned high-side voltage and that is a higher voltage than that in the normal operation. Thus, it is possible to determine that the amplifying apparatus 1 has failed.

In the embodiment, as described above, in the amplifying apparatus including the Doherty amplifier, a failure in an amplifier other than the peak amplifier 16 is determined based on the input signal and the output signal and based on the total gain, and a signal indicating the failure is output from the gain detecting circuit 20.

On the other hand, the potential difference between the two opposite ends of the gate bias resistor 19 connected to the peak amplifier 16 is measured and a signal indicating a failure in the peak amplifier 16 is thus output to the comparator 38 in the failure detecting circuit 30.

As a result, a combined signal of both the signals is output from the amplifying apparatus 1 as a signal for failure determination.

Thus, according to the amplifying apparatus 1 in the embodiment, it is possible to detect a failure in each of amplifiers in an amplifying apparatus including a Doherty amplifier.

In the embodiment, since a failure in the peak amplifier 16 is detected, the voltages at the two opposite ends of the gate bias resistor 19 connected to the peak amplifier 16 are extracted, the difference between both the voltages is amplified, and the amplified difference is sent to the comparator 38. That is, in the embodiment, the amplified voltage difference between the two opposite ends of the gate bias resistor 19 is compared with Vref, and the failure in the peak amplifier 16 is detected in accordance with the comparison result.

Thus, according to the embodiment, even in a case in which a gate-voltage drop due to a failure is small, for example, in a case in which the peak amplifier 16 is implemented by a non-insulated-gate-structure transistor, it is possible to reliably detect the failure. In addition, since the accuracy of Vref for failure determination may be the same level as in the case in which an insulated-gate-structure transistor is used, a failure in the peak amplifier 16 can be detected with a simple configuration.

Also, when a non-insulated-gate-structure transistor is used for the peak amplifier 16, a voltage drop due to a failure is also small and noise, such as fluctuations, is generated in the voltage. Thus, it is difficult to stably detect a failure. In the embodiment, since the failure detection is performed based on the potential difference between two points, it is possible to stably detect a failure including noise.

[Modification]

The transistor failure detection through detection of the two-opposite-end voltages of the gate bias resistor is not limited to the peak amplifier 16, and may also be used for the failure detection of the carrier amplifier 15. In this case, it is sufficient to further provide a differential amplifier for measuring the potential difference between the two opposite ends of the gate bias resistor 18 connected to the carrier amplifier 15 and a comparator for comparing an output voltage from the differential amplifier with Vref.

Such failure detecting means is also applicable to another amplifier using a microwave transistor, such as a balanced amplifier.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present inventions have been described in detail, it should be understood that the various changes, substitutions, and alterations could be made hereto without departing from the spirit and scope of the invention.

**Claims**

1. An amplification apparatus including a plurality of amplifiers comprising:

   a carrier amplifier;
   a peak amplifier including a gate bias circuit including a resistor for supplying a gate bias voltage;
   a comparator for outputting a resultant signal determined by comparison of a predetermined threshold voltage with a voltage across the resistor included within the gate bias circuit; and
   a failure detecting circuit for detecting whether a failure in the plurality of amplifiers is caused or not based on the resultant signal.

2. The amplification apparatus according claim 1, further comprising a differential amplifier for amplifying the voltage drop, wherein the comparator compares the voltage drop amplified by the differential amplifier with the predetermined threshold voltage.

3. The amplification apparatus according claim 1, further comprising a gain detecting circuit for detecting a total gain through a plurality of amplifiers including the carrier amplifier and outputting a second signal correspond to the total gain, wherein the failure detecting circuit outputs a third signal which identifies whether a failure in the amplification apparatus is caused or not based on the second signal and the resultant signal.

4. An amplifier failure detecting method for detecting a failure in a plurality of amplifiers including a carrier amplifier and a peak amplifier comprising:

   comparing a predetermined threshold voltage with a voltage drop across a resistor included within a circuit for supplying a gate bias voltage to the peak amplifier;
   outputting a resultant signal determined in the comparing; and
   detecting and outputting a first signal which detects whether a failure in the plurality of amplifiers is caused or not based on the resultant signal.

**5.** The amplifier failure detecting method according to claim 4, further comprising:

amplifying the voltage drop, wherein the comparing compares the predetermined threshold voltage with a value of the voltage drop amplified by the amplifying.

**6.** The amplifier failure detecting method according to claim 4, further comprising:

detecting a total gain through a plurality of amplifiers including the carrier amplifier and outputting a second signal correspond to the total gain, wherein the detecting and outputting a third signal which detects whether a failure in the plurality of amplifiers is caused or not based on the second signal and the resultant signal.

Fig. 1

Fig. 2

EP 2 106 022 A1

Fig. 3

Fig. 4

Fig. 5

Fig. 6

R1＝R3, R2＝R4

Europäisches
Patentamt

European
Patent Office

Office européen
des brevets

## EUROPEAN SEARCH REPORT

**Application Number**

EP 09 15 4441

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 4 737 733 A (LAPRADE JAMES N [US]) 12 April 1988 (1988-04-12) * column 2, line 39 - line 50; figure 2 * * column 3, line 39 - column 4, line 2 * ----- | 1,2,4,5 | INV. H03F1/02 H03F1/52 |
| Y | US 5 568 086 A (SCHUSS JACK J [US] ET AL) 22 October 1996 (1996-10-22) * column 1, line 30 - line 37 * * column 3, line 20 - line 26; figure 1 * ----- | 1,2,4,5 | |
| A | EP 1 852 970 A (FUJITSU LTD [JP]) 7 November 2007 (2007-11-07) * the whole document * ----- | 1-6 | |
| A | US 5 371 477 A (IKEDA HIKARU [JP] ET AL) 6 December 1994 (1994-12-06) * figure 1 * ----- | 1,2,4,5 | |
| A | FR 2 589 648 A (MITSUBISHI ELECTRIC CORP [JP]) 7 May 1987 (1987-05-07) * page 7, line 6 - line 23; figure 5 * ----- | 1,2,4,5 | |
| | | | TECHNICAL FIELDS SEARCHED (IPC) |
| A | WO 2006/111186 A (FREESCALE SEMICONDUCTOR INC [US]; KAROUI WALID [FR]; MONTORIOL GILLES) 26 October 2006 (2006-10-26) * the whole document * ----- | 1,4 | H03F |

The present search report has been drawn up for all claims

| Place of search | Date of completion of the search | Examiner |
|---|---|---|
| Munich | 29 July 2009 | Kurzbauer, Werner |

EPO FORM 1503 03.82 (P04C01)

## ANNEX TO THE EUROPEAN SEARCH REPORT
## ON EUROPEAN PATENT APPLICATION NO.

EP 09 15 4441

This annex lists the patent family members relating to the patent documents cited in the above-mentioned European search report.
The members are as contained in the European Patent Office EDP file on
The European Patent Office is in no way liable for these particulars which are merely given for the purpose of information.

29-07-2009

| Patent document cited in search report | | Publication date | Patent family member(s) | | Publication date |
|---|---|---|---|---|---|
| US 4737733 | A | 12-04-1988 | FR | 2606230 A1 | 06-05-1988 |
| | | | JP | 63128808 A | 01-06-1988 |
| US 5568086 | A | 22-10-1996 | IT | RM960329 A1 | 13-11-1997 |
| | | | JP | 8330873 A | 13-12-1996 |
| EP 1852970 | A | 07-11-2007 | CN | 101068105 A | 07-11-2007 |
| | | | JP | 2007300528 A | 15-11-2007 |
| | | | KR | 20070107601 A | 07-11-2007 |
| | | | US | 2007285158 A1 | 13-12-2007 |
| US 5371477 | A | 06-12-1994 | NONE | | |
| FR 2589648 | A | 07-05-1987 | US | 4751473 A | 14-06-1988 |
| WO 2006111186 | A | 26-10-2006 | EP | 1875601 A1 | 09-01-2008 |
| | | | JP | 2008537414 T | 11-09-2008 |
| | | | US | 2008211585 A1 | 04-09-2008 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5028111 A
- JP 2003143833 A
- JP 2007300528 A